# EUROPEAN PATENT APPLICATION

(11) **EP 4 553 610 A1**
(43) Date of publication of application: **14.05.2025**
(21) Application number: 24189836.0
(22) Date of filing: 19.07.2024
(51) Int. Cl.: G06F 1/16, H10K 59/80, H10K 50/844

(54) **DISPLAY DEVICE AND METHOD OF MANUFACTURING THE SAME**

(30) Priority: 10.11.2023 KR 20230155680; 21.11.2023 KR 20230162765
(71) Applicant: Samsung Display Co., Ltd., Gyeonggi-do 17113 (KR)
(72) Inventor: Namkung, Jun, 17113 Yongin-si, Gyeonggi-do (KR); Kwak, Byoung Chan, 17113 Yongin-si, Gyeonggi-do (KR); Jeong, Byoung Doo, 17113 Yongin-si, Gyeonggi-do (KR); Jung, Su Jin, 17113 Yongin-si, Gyeonggi-do (KR)
(74) Representative: Gulde & Partner

(57) **Abstract**

A display device includes: a display panel above a substrate, and including a display area;
a window layer above the display panel, and including a window overlapping the display area, and a black matrix adjacent to the window; a metal layer between the display panel and the substrate; a protection member overlapping the black matrix, and covering edges of the display panel including side edges, and corner edges connecting the side edges; and an impact alleviation member between at least one of the edges of the display panel and the protection member, and adjacent to at least one of the corner edges of the display panel.

## Description

### BACKGROUND

### 1. Field

The present disclosure relates to a display device and a method of manufacturing the same.

### 2. Description of the Related Art

Recently, as interest in information display is increased, research and development on a display device is continuously being conducted.

The content described above is only intended to help understanding of the background technology of the technical ideas of the present disclosure, and thus it cannot be understood as a content corresponding to related art known to those skilled in the art of the present disclosure.

### SUMMARY

Embodiments of the present disclosure are for providing a display device with improved reliability.

According to one or more embodiments of the present disclosure, a display device includes a display panel above a substrate, and including a display area, a window layer above the display panel and including a window overlapping the display area, and a black matrix adjacent to the window, a metal layer between the display panel and the substrate, a protection member overlapping the black matrix, and covering edges of the display panel including side edges, and corner edges connecting the side edges, and an impact alleviation member between at least one of the edges and the protection member, and adjacent to at least one of the corner edges.

The impact alleviation member may include ink.

The ink may have an elastic modulus of about 100 Mpa or more and about 1500 Mpa or less. Preferably, between 500 Mpa and 1000 Mpa, more preferably 700 Mpa and 900 Mpa.

The ink may include urethane-based resin, acryl-based resin, ethylene-based resin, or resin.

The ink may include a conductive material.

The impact alleviation member may have a closed loop shape along the edges of the display panel.

The impact alleviation member may be adjacent to at least one of the side edges.

The side edges may include first and second side edges extending in a first direction, and third and fourth side edges extending in a second direction crossing the first direction and shorter than the first and second side edges, the corner edges may include a first corner edge connecting the first side edge and the third side edge, a second corner edge connecting the third side edge and the second side edge, a third corner edge connecting the first side edge and the fourth side edge, and a fourth corner edge connecting the fourth side edge and the second side edge, and the impact alleviation member may be adjacent to the third and fourth corner edges.

A cross-section of the impact alleviation member may have a round end.

The impact alleviation member may have a first surface contacting at least one of the edges of the display panel, and a second surface opposite the first surface, and the second surface has a convex shape toward the protection member.

The protection member and the impact alleviation member may have an elastic property.

The protection member may have a first elastic modulus, and the impact alleviation member may have a second elastic modulus that may be less than the first elastic modulus.

The display device may further include a protection film between the display panel and the metal layer, a polarizing layer between the display panel and the window layer, and an adhesive layer between the polarizing layer and the window layer, and the impact alleviation member may directly contact the metal layer, the protection film, the display panel, and the polarizing layer.

The impact alleviation member may include a first impact alleviation member contacting the metal layer and a second impact alleviation member contacting the polarizing layer, the first impact alleviation member may include first ink, and the second impact alleviation member may include second ink.

The impact alleviation member may include a boundary surface between the first impact alleviation member and the second impact alleviation member.

The impact alleviation member may contact the adhesive layer and a portion of the window layer adjacent to the adhesive layer.

According to one or more other embodiments of the disclosure, relates to a method of manufacturing a display device. The method includes forming a display panel including a display area above a substrate and having edges, providing a window layer including a window overlapping the display area and a black matrix that is adjacent to the window above the display panel, forming a protection member that overlaps the black matrix and that covers the edges of the display panel, and forming an impact alleviation member on at least one of edges of the display panel, which includes side edges and corner edges connecting the side edges, between the at least one of the edges of the display panel and the protection member, and adjacent to at least one of the corner edges of the display panel.

In the method, forming the impact alleviation member may include applying ink to at least one of the edges of the display panel using a nozzle.

The ink may be cured before the protection member is formed at the edges of the display panel.

The method may further include providing a metal layer between the display panel and the substrate, and providing a polarizing layer between the display panel and the window layer. Forming the impact alleviation member may include applying a first ink to contact the metal layer, and applying a second ink to contact the polarizing layer.

### BRIEF DESCRIPTION OF DRAWINGS

The above and other aspects and features of embodiments of the present disclosure will become more apparent by describing in further detail embodiments thereof with reference to the accompanying drawings, in which:
FIG. 1 is a perspective view schematically illustrating a display device according to one or more embodiments of the present disclosure;
FIG. 2 is an exploded perspective view of the display device of FIG. 1;
FIG. 3 is a plan view of the display device of FIG. 1;
FIG. 4 is a cross-sectional view of the display device of FIG. 1;
FIG. 5 is a circuit diagram illustrating one or more embodiments of a pixel included in the display device of FIG. 3;
FIGS. 6 - 9 are plan views illustrating a protection member and impact alleviation members included in a display device according to one or more embodiments;
FIGS. 10 - 12 are cross-sectional views taken along the line I ~ I' of FIG. 6;
FIGS. 13 and 14 are cross-sectional views illustrating a method of manufacturing a display device according to one or more embodiments; and
FIG. 15 is a flowchart schematically illustrating a method of manufacturing a display device according to one or more embodiments of the present disclosure.

### DETAILED DESCRIPTION

Hereinafter, the present disclosure is described in detail with reference to the accompanying drawings. It should be noted that in the following description, only portions necessary for understanding an operation according to the present disclosure are described, and descriptions of other portions are omitted in order not to obscure the subject matter of the present disclosure. In addition, the present disclosure may be embodied in other forms without being limited to embodiments described herein. However, embodiments described herein are provided to describe in detail enough to implement the scope of the present disclosure to those skilled in the art to which the present disclosure belongs.

Throughout the present disclosure, in a case where a portion is "connected" to another portion, the case includes not only a case where the portion is "directly connected" but also a case where the portion is "indirectly connected" with another element interposed therebetween. Terms used herein are for describing specific embodiments and are not intended to limit the present disclosure. Throughout the present disclosure, in a case where a certain portion "includes" means that the portion may further include another component without excluding another component unless otherwise stated. "At least one of X, Y, and/or Z" and "at least one selected from a group consisting of X, Y, and Z" may be interpreted as one X, one Y, one Z, or any combination of two or more of X, Y, and Z (for example, XYZ, XYY, YZ, and ZZ). Here, "and/or" includes all combinations of one or more of corresponding configurations.

Here, terms, such as first and second, may be used to describe various components, but these components are not limited to these terms. These terms are used to distinguish one component from another component. Therefore, a first component may refer to a second component within a range without departing from the scope of the present disclosure.

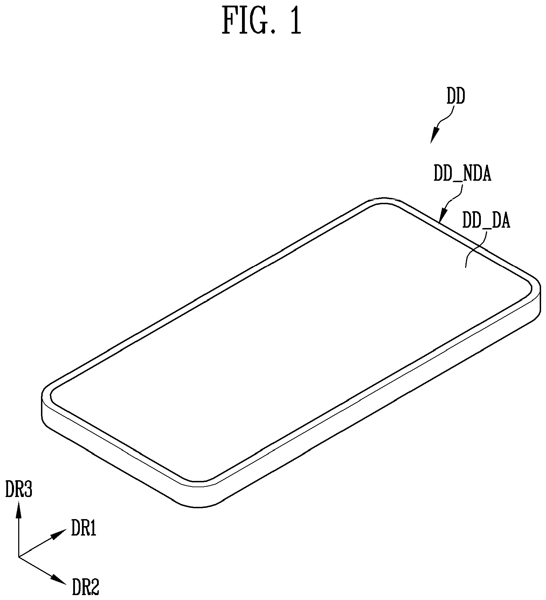

FIG. 1 is a perspective view schematically illustrating a display device according to one or more embodiments of the present disclosure.

Referring to FIG. 1, the display device DD includes a display area DD_DA, and a non-display area DD_NDA around an edge or a periphery of the display area DD_DA (e.g., in a plan view). The display area DD_DA may be an area that displays an image, and the non-display area DD_NDA may be provided around (e.g., surrounding in a plan view) the display area DD_DA. The non-display area DD_NDA is an area where an image is not displayed. According to one or more embodiments, a shape of the display area DD_DA and a shape of the non-display area DD_NDA may be relatively designed.

When the display device DD is an electronic device in which a display surface is applied to one surface, such as a smartphone, a television, a tablet PC, a mobile phone, a video phone, a car navigation system, an e-book reader, a desktop PC, a laptop PC, a netbook computer, a workstation, a server, a PDA, a portable multimedia player (PMP), an MP3 player, a medical device, a camera, and/or a wearable device, the present disclosure may be applied to the display device DD.

The display device DD may be provided in various shapes, and for example, the display device DD may be provided in a rectangular plate shape having two pairs of sides parallel to each other, but the present disclosure is not limited thereto. When the display device DD is provided in the rectangular plate shape, one pair of sides of the two pairs of sides may be provided longer than the other pair of sides. In the drawing, the display device DD has an angled corner portion formed of a straight line, but the present disclosure is not limited thereto. According to one or more embodiments, the display device DD provided in the rectangular plate shape may have a round shape at a corner portion where one long side and one short side contact each other.

In one or more embodiments of the present disclosure, for convenience of description, a case where the display device DD has a rectangular shape having a pair of long sides and a pair of short sides is described, and an extension direction of the long side may be indicated as a first direction DR1, an extension direction of the short side may be indicated as a second direction DR2, and a direction perpendicular to the extension direction of the long side and the short side may be indicated as a third direction DR3 (e.g., a thickness direction). The first to third directions DR1, DR2, and DR3 may refer to directions indicated by the first to third directions DR1, DR2, and DR3, respectively.

In one or more embodiments of the present disclosure, at least a portion of the display device DD may have flexibility and the portion having the flexibility may be folded.

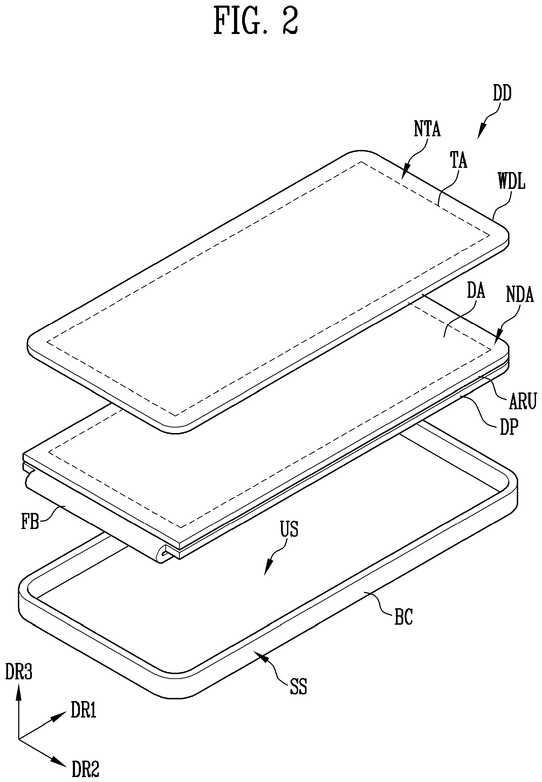

FIG. 2 is an exploded perspective view of the display device of FIG. 1.

Referring to FIG. 2, the display device DD may include a window layer WDL and a display panel DP.

The window layer WDL may be located on a display panel DP to protect the display panel DP, and may transmit an image provided from the display panel DP to a transmission area TA. The window layer WDL may include the transmission area TA, and a non-transmission area NTA around an edge or a periphery of the transmission area TA (e.g., in a plan view). The window layer WDL may include at least one printed layer located on a rear surface of the transmission area TA and the non-transmission area NTA. The print layer may have a suitable color (e.g., a predetermined color). For example, the print layer may be provided in a black color, or may be provided in another color other than a black color.

The transmission area TA may have a shape corresponding to the display area DA of the display panel DP. An image displayed in the display area DA of the display panel DP may be viewed from an outside through the transmission area TA of the window layer WDL.

The non-transmission area NTA may have a shape corresponding to the non-display area NDA of the display panel DP. The non-transmission area NTA may be adjacent to the transmission area TA. The non-transmission area NTA may be an area that overlaps a black matrix, and may reflect or absorb light incident on the transmission area TA. That is, the non-transmission area NTA may be an area of which a light transmittance is comparatively low compared to the transmission area TA. However, the present disclosure is not limited thereto, and the non-transmission area NTA may be omitted.

The display panel DP may be located between the window layer WDL and a receiving member BC. According to one or more embodiments, an optical layer ARU and a circuit board FB may be located between the display panel DP and the window layer WDL.

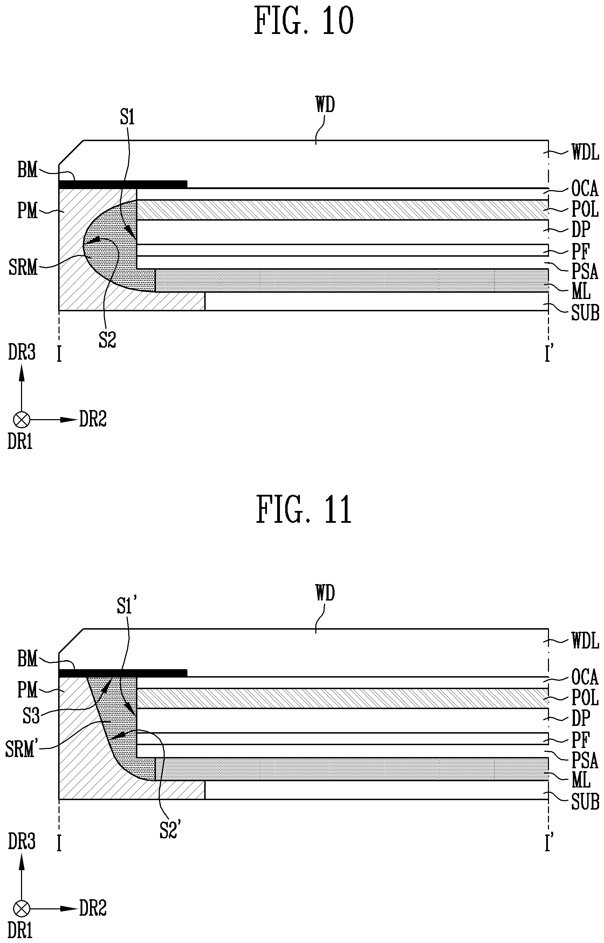

The optical layer ARU may be positioned on the display panel DP. The optical layer ARU may reduce external light reflection. The optical layer ARU may be a polarizing layer POL (refer to FIG. 10), a light-scattering layer, a light-blocking layer, and/or optical functional layers. According to one or more embodiments, the optical layer ARU may include color filters.

The circuit board FB may be provided in an expanded pad area of the display panel DP. As shown in FIG. 2, the circuit board FB may have a structure that is folded and bent along one side surface of the display panel DP. The circuit board FB may be connected to one end (or one side surface) of the display panel DP to provide a driving signal and a suitable voltage (e.g., a predetermined voltage) to the display panel DP. For example, the driving signal may be a signal for displaying an image from the display panel DP, and the suitable voltage (e.g., a predetermined voltage) may be a driving voltage required to drive the display panel DP. The circuit board FB may be provided as a flexible printed circuit board (FPCB). However, the present disclosure is not limited thereto.

In addition, the circuit board FB may process various signals input from a printed circuit board (PCB), and may output the processed signals to the display panel DP. To this end, the circuit board FB may be attached to each of the display panel DP and the printed circuit board (PCB). In one or more embodiments, the printed circuit board (PCB) may be located on a lower surface of the display panel DP opposite to the optical layer ARU.

The receiving member BC may be combined with the window layer WDL. The receiving member BC may provide a rear surface of the display device DD, and may be combined with the window layer WDL to define an internal space. The receiving member BC may include a material having relatively high rigidity. For example, the receiving member BC may be a housing formed of glass, plastic, and/or metal. The receiving member BC may stably protect configurations of the display device DD received in the internal space from external impact. In addition, the receiving member BC is described as including a material having high rigidity, but the present disclosure is not limited thereto and the receiving member BC may include a flexible material. In one or more embodiments, the display device DD according to one or more embodiments of the present disclosure may have a foldable and/or bendable characteristic. As a result, configurations included in the display device DD may also have a flexible property.

The display panel DP may generate an image, and may transfer the generated image to the window layer WDL. For example, as the display panel DP, a display panel capable of self-emitting light, such as an organic light-emitting display panel (OLED panel) that uses an organic light-emitting diode as a light-emitting element, an ultra-small light-emitting diode display panel nano-scale LED display panel) that uses an ultra-small light-emitting diode as a light-emitting element, and/or a quantum dot organic light-emitting display panel (QD OLED panel) that uses a quantum dot and an organic light-emitting diode may be used. In addition, as the display panel DP, a non-emissive display panel, such as a liquid crystal display panel (LCD panel), an electrophoretic display panel (EPD panel), and an electro-wetting display panel (EWD panel), may be used. When the non-emissive display panel is used as the display panel DP, the display device DD may include a backlight unit that supplies light to the display panel DP.

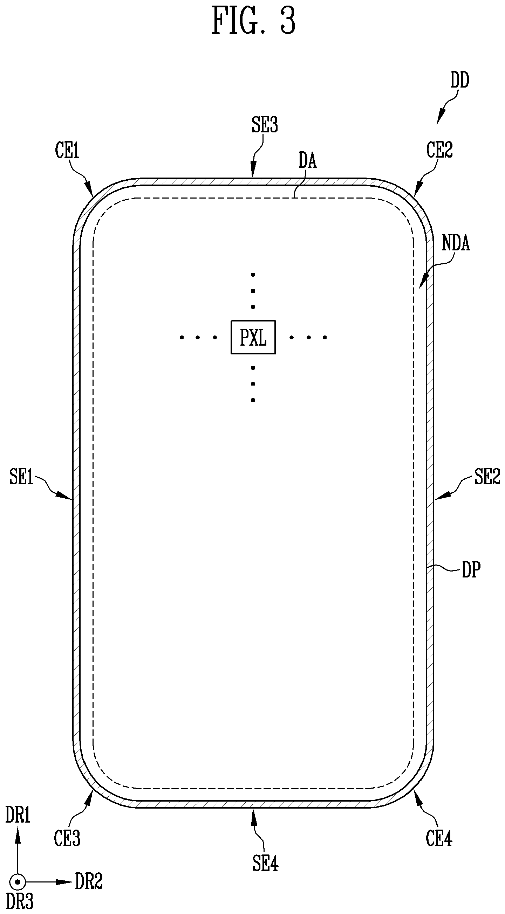

FIG. 3 is a plan view of the display device of FIG. 1.

Referring to FIG. 3, the display panel DP of the display device DD may include a plurality of pixels PXL.

The display panel DP may be formed of one area having an approximately rectangular shape in a plan view. For example, the display panel DP may have a rounded rectangular shape of which an area around a corner is rounded in a plan view. However, the present disclosure is not limited thereto.

The display panel DP may include a plurality of edges surrounding one area. In addition, the plurality of edges may include first to fourth side edges SE1 to SE4 and first to fourth corner edges CE1 to CE4.

According to one or more embodiments, the display panel DP may include the first and second side edges SE1 and SE2 extending in the first direction DR1. The first and second side edges SE1 and SE2 may face (e.g., oppose) each other with the display panel DP interposed therebetween. The display panel DP may include the third and fourth side edges SE3 and SE4 extending in the second direction DR2 crossing the first direction DR1 and shorter than the first and second side edges SE1 and SE2. The third and fourth side edges SE3 and SE4 may face each other with the display panel DP interposed therebetween. The first to fourth side edges SE1 to SE4 may be substantially the same except for positions thereof.

The display panel DP may include the first corner edge CE1 connecting the first side edge SE1 and the third side edge SE3, the second corner edge CE2 connecting the third side edge SE3 and the second side edge SE2, the third corner edge CE3 connecting the first side edge SE1 and the fourth side edge SE4, and the fourth corner edge CE4 connecting the fourth side edge SE4 and the second side edge SE2.

In a plan view, the first to fourth corner edges CE1 to CE4 may have a rounded curved shape. For example, the first corner edge CE1 connecting one side of the first side edge SE1 in the first direction DR1 and one side of the third side edge SE3 in the second direction DR2 may have rounded curved shape in a plan view. However, the present disclosure is not limited thereto.

The display panel DP may include a display area DA and a non-display area NDA. The display area DA may be an area where pixels PXL are provided to display an image, and the non-display area NDA may be an area where the pixels PXL are not provided and may be an area where an image is not displayed. For convenience, only one pixel PXL is shown in FIG. 3, but a plurality of pixels PXL may be provided in the display area DA of the display panel DP.

The display area DA of the display panel DP may correspond to the display area DD_DA of the display device DD, and the non-display area NDA of the display panel DP may correspond to the non-display area DD_NDA of the display device DD. The non-display area NDA may overlap a protection member covering edges of the display panel DP.

The non-display area NDA may be provided on at least one side of the display area DA. The non-display area NDA may be around (e.g., may surround) the display area DA along an edge or a periphery of the display area DA. In the non-display area NDA, a line unit connected to the pixels PXL, and a driver connected to the line unit to drive the pixels PXL, may be provided.

The pixels PXL may be provided in the display area DA of the display panel DP. Each of the pixels PXL may be a minimum unit for displaying an image. The pixels PXL may include a light-emitting element that emits white light and/or color light. Each of the pixels PXL may emit one of red, green, and/or blue, but is not limited thereto, and may emit a color of cyan, magenta, yellow, and/or the like.

The pixels PXL may be arranged in a matrix form along a row extending in the first direction DR1, and along a column extending in the second direction DR2 crossing the first direction DR1. However, an arrangement form of the pixels PXL is not particularly limited and the pixels PXL may be arranged in various forms. In the drawing, the pixels PXL are shown as having a rectangular shape, but the present disclosure is not limited thereto and may be modified into various shapes. In addition, when a plurality of pixels PXL are provided, the plurality of pixels PXL may be provided to have different areas (or sizes). For example, in a case of pixels PXL emitting light of different colors, the pixels PXL may be provided with different areas (or sizes) or different shapes for each color.

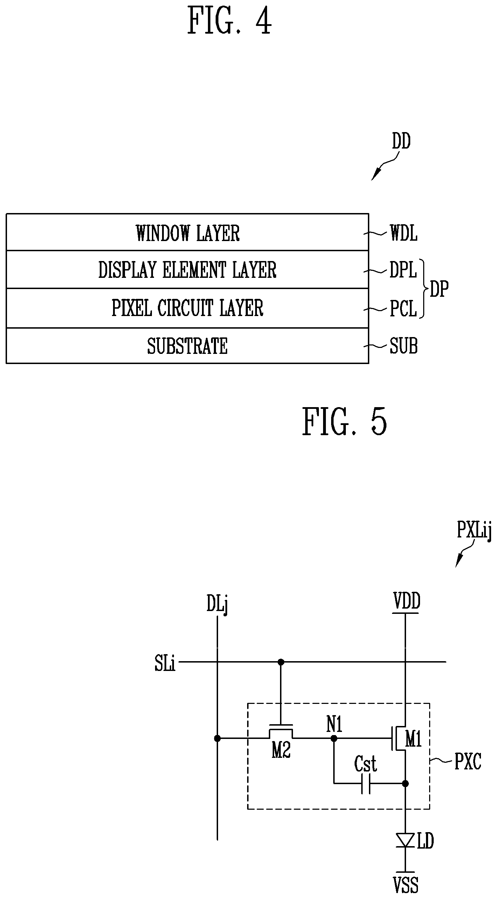

FIG. 4 is a cross-sectional view of the display device of FIG. 1.

Referring to FIG. 4, the display device DD may include a substrate SUB, the display panel DP, and the window layer WDL. In one or more embodiments, the display panel DP may include a pixel circuit layer PCL and a display element layer DPL.

The substrate SUB may include a semiconductor substrate. As an example, the substrate SUB may include a silicon bulk wafer or an epitaxial wafer. The epitaxial wafer may include a crystalline material layer grown by an epitaxial process on a bulk substrate, that is, an epitaxial layer. The substrate SUB is not limited to the bulk wafer or the epitaxial wafer, and may be formed using various wafers, such as a polished wafer, an annealed wafer, and/or a silicon on insulator (SOI) wafer.

The pixel circuit layer PCL may be provided on the substrate SUB and may include a plurality of transistors and signal lines connected to the transistors. For example, each transistor may be a device in which a semiconductor layer, a gate electrode, a first terminal, and a second terminal are sequentially stacked with one or more insulating layers interposed therebetween. The semiconductor layer may include amorphous silicon, poly silicon, low temperature poly silicon, and/or an organic semiconductor. The gate electrode, the first terminal, and the second terminal of the transistor may include one of aluminum (Al), copper (Cu), titanium (Ti), and/or molybdenum (Mo), but the present disclosure is not limited thereto. In addition, the pixel circuit layer PCL may include at least one insulating layer.

The display element layer DPL may be located on the pixel circuit layer PCL. The display element layer DPL may include a light-emitting element configured to emit light. The light-emitting element may be, for example, an organic light-emitting diode (OLED), but the present disclosure is not limited thereto. According to one or more embodiments, the light-emitting element may be an inorganic light-emitting element including an inorganic light-emitting material or a light-emitting element that emits light by changing a wavelength of emitted light using a quantum dot.

The window layer WDL may be located on the display element layer DPL. The window layer WDL may protect the display panel DP from an external scratch and impact. The window layer WDL may be optically transparent. For example, the window layer WDL may be formed of a glass substrate, a plastic film, a plastic substrate, and/or the like. In addition, although the window layer WDL is shown as a single layer, the window layer WDL may include a plurality of layers. That is, the window layer WDL may have a selected multilayer structure. The multilayer structure may be formed through a continuous process or an adhesion process using an adhesive layer.

A touch sensor may be further located between the display panel DP and the window layer WDL. The touch sensor may be located directly on a surface of the display panel DP where an image is emitted and may receive a user's touch input.

FIG. 5 is a circuit diagram illustrating one or more embodiments of the pixel included in the display device of FIG. 3.

In FIG. 5, for convenience of description, a pixel PXLij located in an i-th row and j-th column are shown as an example.

Referring to FIG. 5, the pixel PXLij may include a pixel circuit PXC connected to an i-th scan line SLi and a j-th data line DLj, and a light-emitting element LD connected to the pixel circuit PXC.

According to one or more embodiments, the light-emitting element LD may be selected as an organic light-emitting diode (OLED). In addition, the light-emitting element LD may be selected as an inorganic light-emitting diode, such as a micro light-emitting diode (LED) or a quantum dot LED. In addition, the light-emitting element LD may be an element configured of an organic material and/or an inorganic material in combination.

The pixel circuit PXC is configured to receive a data voltage provided through a j-th data line DLj when a gate on signal is applied to an i-th scan line SLi. The pixel circuit PXC is configured to provide a driving current according to a received data voltage to the light-emitting element LD. For example, the pixel circuit PXC may include first and second transistors M1 and M2 and a storage capacitor Cst.

According to one or more embodiments, the first transistor M1 may include a drain electrode connected to first power VDD, a source electrode connected to a pixel electrode (for example, an anode electrode of the light-emitting element LD), and a gate electrode connected to a first node N1. According to one or more embodiments, the drain electrode and the source electrode of the first transistor M1 may be changed according to a polarity of a voltage applied to the first transistor M1 and/or a type of the first transistor M1.

The first transistor M 1 may control the driving current flowing from the first power VDD to second power VSS via the light-emitting element LD in response to a voltage of the first node N1. That is, the first transistor M1 may be a driving transistor that controls the driving current of the pixel PXLij. According to one or more embodiments, the first power VDD and the second power VSS may be a high-potential pixel power and a low-potential pixel power, respectively.

According to one or more embodiments, the second transistor M2 may include a drain electrode connected to the j-th data line DLj, a source electrode connected to the first node N1, and a gate electrode connected to the i-th scan line SLi. According to one or more embodiments, the drain electrode and the source electrode of the second transistor M2 may be changed according to a polarity of a voltage applied to the second transistor M2 and/or a type of the second transistor M2. The second transistor M2 may be turned on when a scan signal having a gate on voltage (for example, a high voltage) is supplied from the i-th scan line SLi. When the second transistor M2 is turned on, the j-th data line DLj and the first node N1 may be electrically connected. That is, the second transistor M2 may be a switching transistor that controls a connection between the pixel PXLij and the j-th data line DLj.

According to one or more embodiments, the storage capacitor Cst may be connected between one electrode, for example, the source electrode, of the first transistor M1 and the first node N1. The storage capacitor Cst may store a voltage corresponding to the data signal supplied to the first node N1, and may maintain the stored voltage during a suitable period (e.g., a predetermined period). For example, the storage capacitor Cst may maintain the stored voltage until a data signal of a next frame is supplied. According to one or more embodiments, a connection position of the storage capacitor Cst may be changed. For example, the storage capacitor Cst may be connected between the first power VDD and the first node N1.

According to one or more embodiments, the light-emitting element LD may be connected between the first transistor M1 and the second power VSS. For example, the light-emitting element LD may include the anode electrode connected to the source electrode of the first transistor M1 and a cathode electrode connected to the second power VSS. The light-emitting element LD may emit light with a luminance corresponding to the driving current controlled by the first transistor M1.

In FIG. 5, one or more embodiments in which the first and second transistors M1 and M2 are implemented as N-type transistors is disclosed, but the present disclosure is not limited thereto. For example, at least one of the first and second transistors M1 and M2 may be implemented as a P-type transistor.

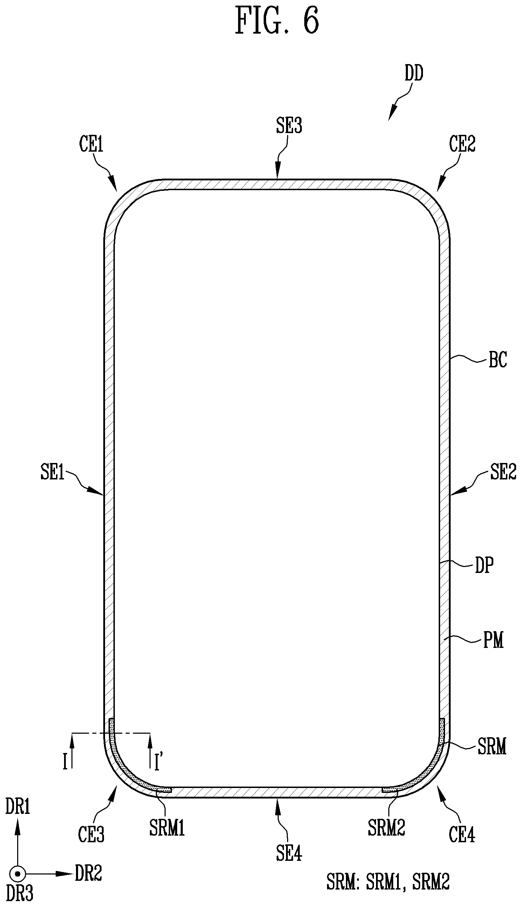

FIGS. 6 - 9 are plan views illustrating a protection member and impact alleviation members included in a display device according to one or more embodiments.

FIGS. 6 - 9 may show a position where the protection member PM and the impact alleviation member SPM are located when the display device DD is viewed from the third direction D3. However, FIGS. 6 - 9 are shown excluding the window layer WDL (refer to FIG. 2).

According to one or more embodiments, the display device DD may include the display panel DP located between the window layer WDL (refer to FIG. 2) and the receiving member BC.

The display device DD may include the protection member PM that covers the edges of the display panel DP. The protection member PM may overlap a black matrix of the window layer WDL, and to cover the edges of the display panel DP. The protection member PM may have an elastic property. Accordingly, the protection member PM may absorb external impact applied to the display panel DP. In addition, the protection member PM may have a large elastic modulus (modulus of elasticity). For example, the modulus of elasticity of the protection member PM may be about 2Gpa or more. Accordingly, the protection member PM may have high physical strength, such as high hardness, durability, and/or scratch resistance. However, the elastic modulus of the protection member PM is an example, and is not limited thereto.

Referring to FIGS. 6 - 9, the protection member PM may be located outside the display panel DP and may be around (e.g., may surround) the display panel DP. The protection member PM may be located in a closed loop shape between the display panel DP and the receiving member BC. For example, the protection member PM may extend in the first direction DR1 along the first and second side edges SE1 and SE2. The protection member PM may extend in the second direction DR2 along the third and fourth side edges SE3 and SE4. In addition, the protection member PM may extend in a curved shape along the first to fourth corner edges CE1 to CE4. The protection member PM may be around (e.g., may surround in a plan view) an outside of the display panel DP along the first to fourth corner edges CE1 to CE4 and the first to fourth side edges SE1 to SE4. Hereinafter, the protection member PM may be described similarly to the protection member PM of FIG. 6. An overlapping description thereof is omitted.

The display device DD may further include an impact alleviation member SRM located between the display panel DP and the protection member PM. At least a portion of the impact alleviation member SRM may be located between the display panel DP and the protection member PM. In addition, the impact alleviation member SRM may have a small elastic modulus. The elastic modulus of the impact alleviation member SRM may be less than that of the protection member PM. For example, the elastic modulus of the impact alleviation member SRM may be about 100 MPa or more and about 1500 MPa or less. However, the elastic modulus of the impact alleviation member SRM is an example, and is not limited thereto when the elastic modulus of the impact alleviation member SRM is less than the elastic modulus of the protection member PM. The impact alleviation member SRM having a small elastic modulus may absorb external impact applied to the display panel DP together with the protection member PM, thereby further preventing or alleviating deformation of the display panel DP.

Referring to FIG. 6, the impact alleviation member SRM may be adjacent to at least one of the first to fourth corner edges CE1 to CE4. For example, the third and fourth corner edges CE3 and CE4 corresponding to a lower portion of the display panel DP may be severely deformed due to impact when dropped. According to one or more embodiments of the present disclosure, the impact alleviation member SRM may be adjacent to the third and fourth corner edges CE3 and CE4 to protect the third and fourth corner edges CE3 and CE4. For example, a first impact alleviation member SRM1 may be adjacent to the third corner edge CE3. A second impact alleviation member SRM2 may be adjacent to the fourth corner edge CE4. The first and second impact alleviation members SRM1 and SRM2 may be spaced from each other, and may be adjacent to the third and fourth corner edges CE3 and CE4, respectively. As described above, by disposing the impact alleviation member SRM in a minimum area, deformation of the display panel DP may be effectively prevented or alleviated.

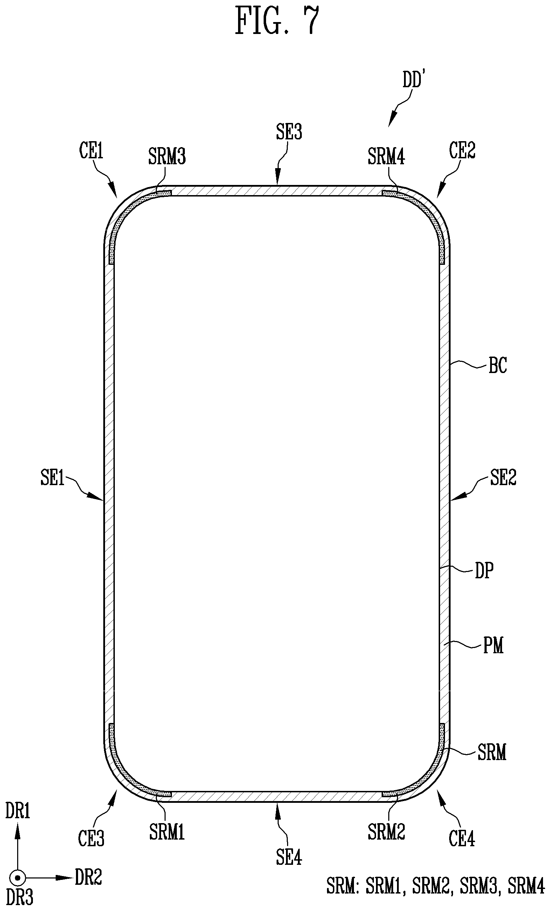

Referring to FIG. 7, the impact alleviation member SRM may be adjacent to each of the first to fourth corner edges CE1 to CE4. For example, interface delamination due to impact may occur at the first to fourth corner edges CE1 to CE4 of the display panel DP. According to one or more embodiments of the present disclosure, the impact alleviation member SRM may be adjacent to each of the first to fourth corner edges CE1 to CE4. For example, a first impact alleviation member SRM1 may be adjacent to the third corner edge CE3. A second impact alleviation member SRM2 may be adjacent to the fourth corner edge CE4. A third impact alleviation member SRM3 may be adjacent to the first corner edge CE1. A fourth impact alleviation member SRM4 may be adjacent to the second corner edge CE2. The first to fourth impact alleviation members SRM1 to SRM4 may be spaced from each other and may be adjacent to the first to fourth corner edges CE1 to CE4. As described above, by arranging the impact alleviation member SRM at all corner edges, deformation occurring at the corner edges of the display panel DP may be prevented or alleviated.

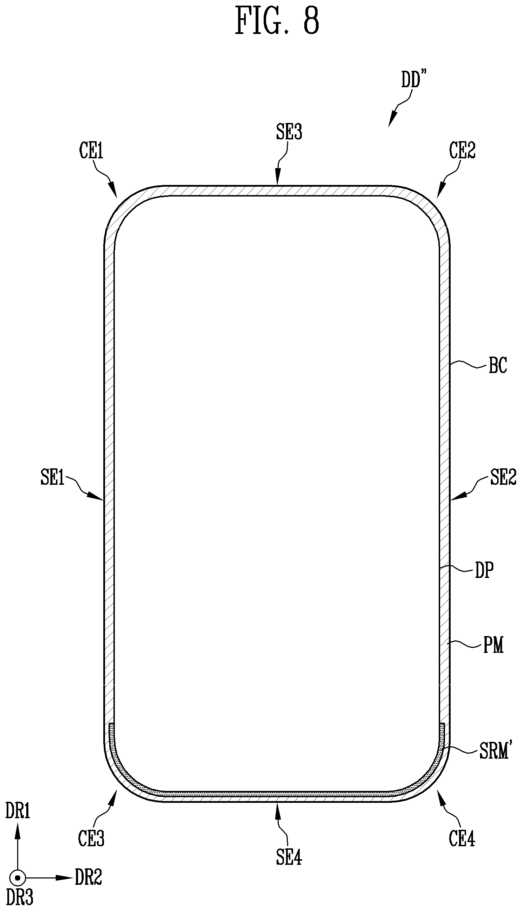

Referring to FIG. 8, an impact alleviation member SRM' may be adjacent to at least one of the first to fourth corner edges CE1 to CE4. Similarly, the impact alleviation member SRM' may be adjacent to at least one of the first to fourth side edges SE1 to SE4. For example, the third and fourth corner edges CE3 and CE4 and the fourth side edge SE4 between the third and fourth corner edges CE3 and CE4 may correspond to the lower portion of the display panel DP. The lower portion of the display panel DP may be an area that may be deformed by impact when dropped. Accordingly, the impact alleviation member SRM' may be adjacent to the third and fourth corner edges CE3 and CE4 and adjacent to the fourth side edge SE4 located between the third and fourth corner edges CE3 and CE4. For example, the impact alleviation member SRM' may be adjacent to the third corner edge CE3 to the fourth corner edge CE4. In addition, the impact alleviation member SRM' may extend in the second direction DR2 along the fourth side edge SE4 between the third and fourth corner edges CE3 and CE4. As described above, by having the impact alleviation member SRM' around (e.g., surrounding in a plan view) the lower portion of the display panel DP, deformation of the display panel DP may be prevented or alleviated.

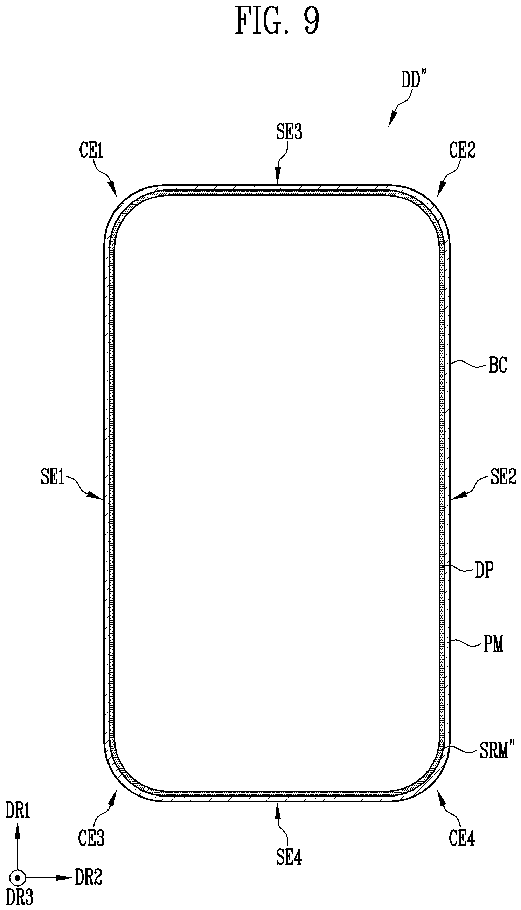

Referring to FIG. 9, an impact alleviation member SRM" may be adjacent to the first to fourth corner edges CE1 to CE4 and the first to fourth side edges SE1 to SE4. In addition, the impact alleviation member SRM" may be in a closed loop shape between the display panel DP and the protection member PM. As an example, the impact alleviation member SRM" may be continuous along the first to fourth corner edges CE1 to CE4 and the first to fourth side edges SE1 to SE4 to be around (e.g., to surround in plan view) the display panel DP. Accordingly, the impact alleviation member SRM" may have a shape similar to that of the display panel DP in a plan view. For example, when the display panel DP has a rectangular shape, the impact alleviation member SRM", which is in a closed loop shape to be around (e.g., to surround in plan view) the outside of the display panel DP, may have a rectangular shape in which an opening is formed. As described above, by having the impact alleviation member SRM" around (e.g., surrounding in a plan view) the display panel DP, deformation of the display panel DP may be entirely prevented or alleviated.

FIGS. 10 - 12 are cross-sectional views taken along the line I - I' of FIG. 6.

Referring to FIGS. 10 - 12, the display device DD may include the substrate SUB, a metal layer ML, an adhesive film PSA, a protection film PF, the display panel DP, the polarizing layer POL, the adhesive layer OCA, and the window layer WDL. Hereinafter, the substrate SUB, the display panel DP, and the window layer WDL may be described similarly to FIG. 4 described above. An overlapping description thereof is omitted.

A relative length between the adhesive film PSA, the protection film PF, the display panel DP, the polarizing layer POL, or the adhesive layer OCA on the cross-sections shown in FIGS. 10 - 12 may be changed, and is not limited thereto.

The metal layer ML may be located between the display panel DP and the substrate SUB. In addition, the metal layer ML may be directly located on the protection film PF located on one side of the display panel DP. The metal layer ML may be rigid. However, the present disclosure is not limited thereto, and at least a portion of the metal layer ML may be flexible. For example, the metal layer ML may include a metal material, such as stainless steel, aluminum, iron, and/or copper. Alternatively, the metal layer ML may include carbon graphite. However, the present disclosure is not limited thereto. The metal layer ML may reduce or prevent damage to the display device DD due to external impact. In addition, the metal layer ML may reduce or prevent a luminance change due to a temperature deviation of the display panel DP by dissipating heat of the display panel DP.

The adhesive film PSA may combine the metal layer ML and the protection film PF. The adhesive film PSA may be a pressure-sensitive adhesive film. In addition, when pressure is applied to the adhesive film PSA, an adhesive material may act, and thus an adhesive may be attached to an adhesive surface. For example, the adhesive film PSA may include a conventional adhesive or a sticking agent, and may include a sheet type or a resin type.

The protection film PF may be located on a lower surface of the display panel DP. The protection film PF may reduce or prevent external moisture permeating into the display panel DP, and may absorb external impact. For example, the protection film PF may include a plastic film as a base substrate. The protection film PF may include a plastic film including one selected from a group consisting of polyethersulfone (PES), polyacrylate, polyetherimide (PEI), polyethylene naphthalate (PEN), polyethylene terephthalate (PET), polyphenylene sulfide (PPS), polyarylate, polyimide (PI), polycarbonate (PC), polyarylene ethersulfone, and a combination thereof. However, a material configuring the protection film PF is not limited to plastic resins and may include organic/inorganic composite materials.

The polarizing layer POL may be located between the window layer WDL and the display panel DP. The polarizing layer POL may control polarization of external light incident through a window WD of the window layer WDL. For example, one component of external light incident on the polarizing layer POL may be absorbed or reflected and may not pass through the polarizing layer POL. On the other hand, a component perpendicular to one component of the external light incident on the polarizing layer POL may pass through the polarizing layer POL. In addition, the polarizing layer POL may include a polymer resin stretched in a specific direction. However, the present disclosure is not limited thereto.

The adhesive layer OCA may be located between the polarizing layer POL and the window layer WDL. The adhesive layer OCA may be a transparent adhesive layer of which light transmittance is high, such as an optically clear adhesive film or an optically clear adhesive resin. Alternatively, the adhesive layer OCA may be a pressure-sensitive adhesive film. The adhesive layer OCA may include substantially the same material as the adhesive film PSA.

In FIG. 10, the adhesive layer OCA is shown as having the same length as the display panel DP under the window layer WDL, but is not limited thereto. For example, the adhesive layer OCA may have a length that is longer or shorter than the display panel DP at side edges of the display panel DP.

The window layer WDL may include the window WD overlapping the display area DA (refer to FIG. 2) and a black matrix BM adjacent to the window WD. The black matrix BM may be positioned on one surface of the window layer WDL facing the display panel DP. The black matrix BM may define the non-transmission area NTA of the window layer WDL. In one or more embodiments, the black matrix BM may be formed of a colored organic layer, and may be formed on one surface of the window layer WDL in a coating or printing method. Alternatively, in other embodiments, the black matrix BM may be formed on a base layer, such as a separate transparent film, and the base layer on which the black matrix BM is formed may be attached to one surface of the window WD.

Referring to FIG. 10, the impact alleviation member SRM may be located under the window layer WDL. The impact alleviation member SRM may be formed to contact at least one of a plurality of layers located under the window layer WDL. In addition, the impact alleviation member SRM may be formed to be spaced from the window layer WDL so as not to contact the window layer WDL. As an example, the impact alleviation member SRM may directly contact one side surfaces of the metal layer ML and the display panel DP. However, the impact alleviation member SRM might not contact one surface of the window layer WDL. For example, the impact alleviation member SRM may directly contact one side surface of the metal layer ML, the adhesive film PSA, the protection film PF, the display panel DP, and the polarizing layer POL.

According to one or more embodiments, the impact alleviation member SRM may have a round shape in a cross-sectional view. The impact alleviation member SRM may be formed to protrude from one side surfaces of the metal layer ML and the display panel DP in the first direction DR1 or the second direction DR2. For example, the impact alleviation member SRM may have a first surface S1 contacting at least one of the edges of the display panel DP, and a second surface S2 facing the first surface S1. The second surface S2 may have a convex shape in a direction toward the protection member PM.

The impact alleviation member SRM may include ink. The impact alleviation member SRM may be formed by applying the ink to at least one of the edges of the display panel DP. Here, the ink may include a material with a small elastic modulus and with a high impact absorption rate. In addition, the ink may be conductive ink or non-conductive ink. For example, the ink may include urethane-based resin, acryl-based resin, ethylene-based resin, or resin. For example, the impact alleviation member SRM may include phenylene, polyethylene terephthalate (PET), polyimide, polyamide, polyethylene naphthalate (PEN), polycarbonate, and/or the like. However, the present disclosure is not limited thereto.

The protection member PM may be located under the window layer WDL. The protection member PM may be adjacent to the edges of the display panel DP to support a lower portion of the window layer WDL. According to one or more embodiments, the protection member PM may be formed under the window layer WDL along an outside of the window layer WDL, and may overlap the black matrix BM in the third direction DR3.

The protection member PM may be formed after forming the impact alleviation member SRM. For example, the protection member PM may be formed after the ink of the impact alleviation member SRM is cured.

According to one or more embodiments, the protection member PM may be formed to contact the impact alleviation member SRM. The protection member PM may be formed to contact at least one of a plurality of layers located under the window layer WDL with the impact alleviation member SRM interposed therebetween. For example, the protection member PM may directly contact the substrate SUB and the adhesive layer OCA. On the other hand, the protection member PM may contact the metal layer ML, the adhesive film PSA, the protection film PF, the display panel DP, and the polarizing layer POL with the impact alleviation member SRM interposed therebetween. However, this is only an example, and layers contacting the protection member PM may change according to the impact alleviation member SRM.

The protection member PM may include a material having an elastic modulus greater than that of the impact alleviation member SRM. For example, the protection member PM may be urethane-based resin, acryl-based resin, ethylene-based resin, or resin. For example, the protection member PM may include a LOMA material. However, the present disclosure is not limited thereto.

In addition, to avoid an overlapping description in relation to embodiments of FIG. 10, a point different from the above-described embodiments is mainly described.

Referring to FIG. 11, the impact alleviation member SRM' may be located under the window layer WDL. The impact alleviation member SRM' may be formed to contact at least one of a plurality of layers located under the window layer WDL. In addition, the impact alleviation member SRM' may be formed to contact a portion of the window layer WDL. For example, the impact alleviation member SRM' may directly contact one side surfaces of the metal layer ML, the adhesive film PSA, the protection film PF, the display panel DP, the polarizing layer POL, and the adhesive layer OCA. In addition, the impact alleviation member SRM' may directly contact the black matrix BM of the window layer WDL adjacent to the adhesive layer OCA.

In addition, the impact alleviation member SRM' may have an inclined surface in a cross-sectional view. For example, the impact alleviation member SRM' may have a first surface S1' contacting at least one of the edges of the display panel DP, a second surface S2' facing the first surface S1', and a third surface S3 contacting the window layer WDL. The second surface S2' may have an inclined surface. However, this is an example and is not limited thereto.

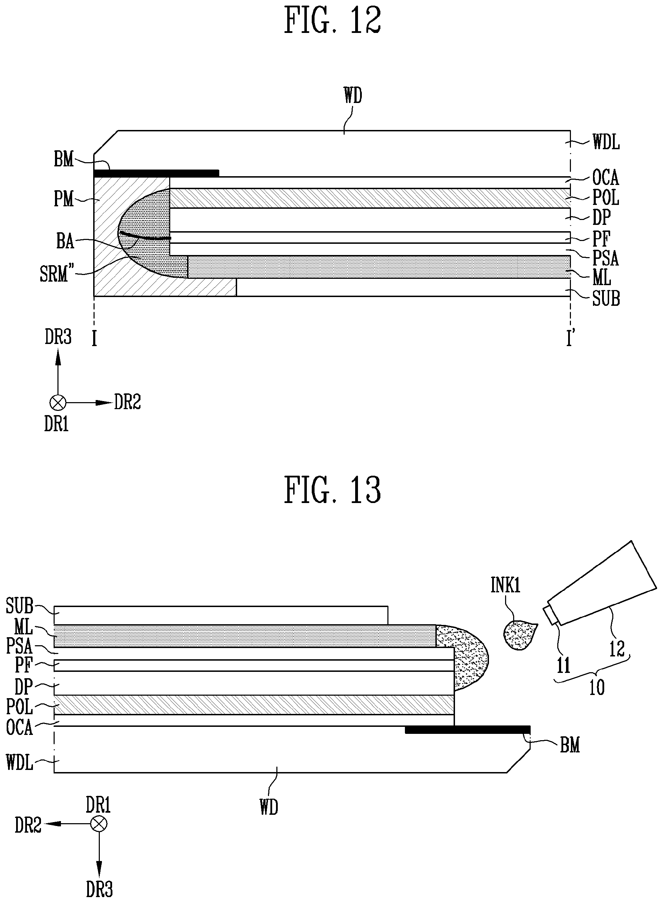

Referring to FIG. 12, an impact alleviation member SRM" may include a boundary surface BA therein. The impact alleviation member SRM" may be formed by applying ink to at least one of the edges of the display panel DP. The ink may be applied in a first stage or a plurality of stages. For example, the ink may be applied in a first stage using two nozzles of discharge capacities that are different from each other. In addition, the ink may be applied in a plurality of stages using a single nozzle by adjusting an application time and/or an application speed at each application point.

In one or more embodiments, when the impact alleviation member SRM" is formed by applying the ink in first and second stages, the impact alleviation member SRM" may include the boundary surface BA between a portion contacting the metal layer ML and a portion contacting the polarizing layer POL. For example, the impact alleviation member SRM" may include the boundary surface BA between ink applied and cured in the first stage and ink applied and cured in the second stage. However, the impact alleviation member SRM" may include the boundary surface BA according to a manufacturing method of the impact alleviation member SRM", but is not limited thereto. For example, when the ink applied in the first stage and the ink applied in the second stage are cured concurrently (e.g., simultaneously), the impact alleviation member SRM" might not include the boundary surface BA.

Details regarding a method of forming the impact alleviation member SRM" are described later with reference to FIGS. 13 - 15.

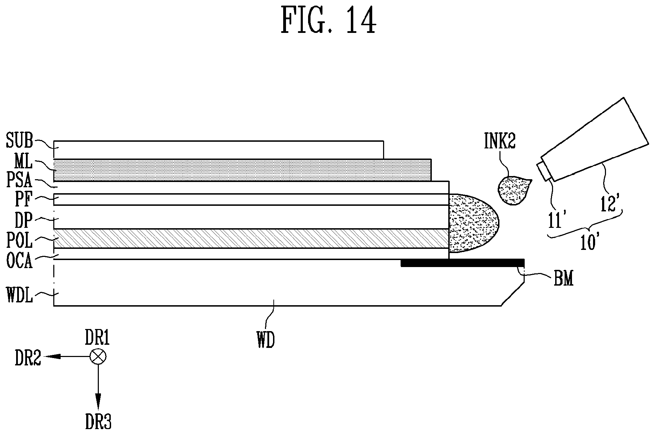

FIGS. 13 and 14 are cross-sectional views illustrating a method of manufacturing a display device according to one or more embodiments.

FIGS. 13 and 14 are cross-sectional views schematically illustrating a method of manufacturing the display device DD (refer to FIG. 3) according to one or more embodiments.

Hereinafter, ink application for forming the impact alleviation member SRM is described using a nozzle application method as an example, but is not limited thereto. For example, various methods, such as inkjet method and/or screen application method, may be applied.

Referring to FIG. 13, after combining a plurality of layers including the display panel DP on the window layer WDL, inks for forming the impact alleviation member SRM (refer to FIG. 10) may be applied.

According to one or more embodiments, a printing device 10 that applies the inks may be positioned on the display panel DP. The printing device 10 may include a head 12, and a nozzle 11 provided under the head 12. The nozzle 11 may be a single nozzle or a multi-nozzle including at least two types of nozzles. In addition, the nozzle 11 may include a quadrangular shape, an oval shape, and/or a circular shape. However, a shape and a size of the nozzle 11 may be appropriately selected and are not limited thereto. In one or more embodiments, in FIGS. 13 and 14, the printing device 10 may further include a reservoir that stores the ink of a liquid form and is connected to the nozzle 11.

The printing device 10 may apply first ink INK1 to at least one of the edges of the display panel DP. In addition, the first ink INK1 applied to the corresponding edge of the display panel DP may also be applied to the metal layer ML as well as to the adhesive film PSA, the protection film PF. As an example, the first ink INK1 may be sprayed on one side of the metal layer ML through a printing process using the printing device 10. The first ink INK1 may be sprayed through the nozzle 11 included in the printing device 10. The first ink INK1 discharged from the nozzle 11 may be applied to one side of the metal layer ML adjacent to the edges of the display panel PD. The applied first ink INK1 may have a shape extending in the first direction DR1 or the second direction DR2. In addition, the first ink INK1 may have a round shape in a cross-section due to surface tension.

Referring to FIG. 14, the printing device 10 may apply second ink INK2 again after the application of the first ink INK1 is completed to at least one of the edges of the display panel DP. In addition, the second ink INK2 applied to the corresponding edge of the display panel DP may also be applied to the polarizing layer POL. For example, through a printing process using a printing device 10', the second ink INK2 may be sprayed lower than a point where the first ink INK1 is applied. The second ink INK2 may be sprayed through a nozzle 11' included in the printing device 10' (that also includes the head 12'). The second ink INK2 may be the same ink as the first ink INK1. The second ink INK2 discharged from the nozzle 11' may be applied to one side of the polarizing layer POL adjacent to the edges of the display panel PD. The applied second ink INK2 may have a shape extending in the first direction DR1 or the second direction DR2. In addition, the second ink INK2 may have a round shape in a cross-section due to surface tension.

The second ink INK2 may be applied before the first ink INK1 is cured. In this case, the impact alleviation member SRM" (refer to FIG. 12) formed by the first and second inks INK1 and INK2 might not include the boundary surface BA (refer to FIG. 12) therein. On the other hand, the second ink INK2 may be applied even after the first ink INK1 is cured. In this case, the impact alleviation member SRM" (refer to FIG. 12) formed by the first and second inks INK1 and INK2 may include the boundary surface BA (refer to FIG. 12) therein.

According to one or more embodiments, the first and second inks INK1 and INK2 may be cured before the protection member PM is formed at the edges of the display panel DP. For example, the first and second inks INK1 and INK2 may be cured by light (for example, ultraviolet rays) irradiated to each of the first and second inks INK1 and INK2. However, the present disclosure is not limited thereto.

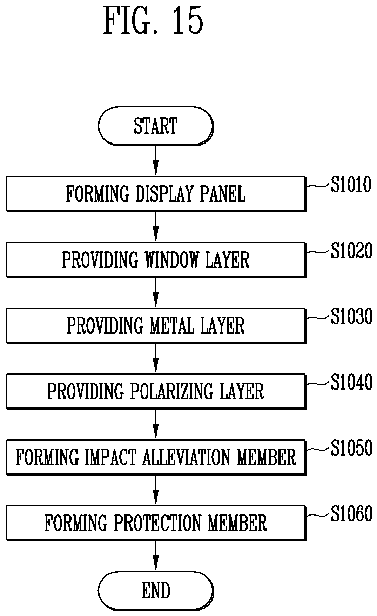

FIG. 15 is a flowchart schematically illustrating a method of manufacturing a display device according to one or more embodiments of the present disclosure. A content overlapping the content described with reference to FIGS. 6 - 14 may be omitted.

Referring to FIG. 15, the method of manufacturing the display device DD may include forming the display panel S1010, providing the window layer S1020, providing the metal layer S1030, providing the polarizing layer S1040, forming the impact alleviation member S1050, and forming the protection member S1060.

Hereinafter, a manufacturing step of the display device DD is performed sequentially, but unless the present disclosure is changed, some steps shown as being performed sequentially may be performed concurrently (e.g., simultaneously), the order of each step may be changed, some steps may be omitted, or another step may be further included between each step.

Referring to FIGS. 10 and 12, in S1010, the display panel DP may be formed. According to one or more embodiments, step S1010 may form the display panel DP including the display area on the substrate SUB. The display panel DP may include a plurality of edges surrounding one area. In addition, the plurality of edges may include the first to fourth side edges SE1 to SE4 (refer to FIG. 3) and the first to fourth corner edges CE1 to CE4 (refer to FIG. 3).

In S1020, the window layer WDL may be provided. According to one or more embodiments, step S1020 may provide the window layer including the window WD overlapping the display area and the black matrix BM adjacent to the window WD on the display panel DP.

In S1030, the metal layer ML may be provided. According to one or more embodiments, step S1030 may provide the metal layer ML located between the display panel DP and the substrate SUB.

In S1040, the polarizing layer POL may be provided. According to one or more embodiments, step S1040 may provide the polarizing layer POL located between the window layer WDL and the display panel DP.

In S1050, the impact alleviation member SRM may be formed. According to one or more embodiments, step S1050 may form the impact alleviation member SRM adjacent to at least one of the edges of the display panel DP. After combining a plurality of layers including the display panel DP on the window layer WDL, ink may be applied to form the impact alleviation member.

For example, the impact alleviation member SRM may be formed by applying the ink to at least one of the edges of the display panel DP using a nozzle. For example, the impact alleviation member SRM may be formed by applying the ink in first and second stages. The ink may be applied to one side of the metal layer ML adjacent to the edges of the display panel DP in the first stage. In addition, the ink may be applied to one side of the polarizing layer POL adjacent to the edges of the display panel PD in the second stage.

The impact alleviation member SRM may be formed by applying the ink adjacent to at least one of the first to fourth corner edges CE1 to CE4. For example, the ink may be applied to the third and fourth corner edges CE3 and CE4 of the display panel DP. Accordingly, the impact alleviation member SRM may be formed adjacent to the third and fourth corner edges CE3 and CE4. Alternatively, the ink may be applied to each of the first to fourth corner edges CE1 to CE4. Accordingly, the impact alleviation member SRM may be formed adjacent to the first to fourth corner edges CE1 to CE4.

The impact alleviation member SRM may be formed by applying the ink adjacent to at least one of the first to fourth side edges SE1 to SE4. For example, the ink may be applied to the third and fourth corner edges CE3 and CE4 and the fourth side edge SE4 between the third and fourth corner edges CE3 and CE4. Accordingly, the impact alleviation member SRM may be formed adjacent to the third and fourth corner edges CE3 and CE4 and the fourth side edge SE4 between the third and fourth corner edges CE3 and CE4. Alternatively, the ink may be applied to be around (e.g., to surround in plan view) an outside of the display panel DP along the first to fourth corner edges CE1 to CE4 and the first to fourth side edges SE1 to SE4. Accordingly, the impact alleviation member SRM may be formed adjacent to the first to fourth corner edges CE1 to CE4 and the first to fourth side edges SE1 to SE4. Here, the ink may include a material with a relatively small elastic modulus and a high impact absorption rate. In addition, the ink may be conductive ink or non-conductive ink. For example, the ink may include urethane-based resin, acryl-based resin, ethylene-based resin, and/or resin.

The impact alleviation member SRM may be cured before the protection member PM is formed at the edges of the display panel DP. The ink included in the impact alleviation member SRM may be cured by irradiation with light (for example, ultraviolet rays).

In S1060, the protection member PM may be formed. According to one or more embodiments, in step S1060, the protection member PM may be formed to be around (e.g., to surround) the edges of the display panel DP. As an example, the protection member PM may be formed in a closed loop shape between the display panel DP and the receiving member BC. For example, the protection member PM may be formed to be around (e.g., to surround) an outside of the display panel DP along the first to fourth corner edges CE1 to CE4 and the first to fourth side edges SE1 to SE4. Accordingly, the impact alleviation member SRM may be located at least partially between the protection member PM and the display panel DP.

As described above, by incorporating the impact alleviation member SRM on at least one of the edges of the display panel DP, the impact alleviation member SRM may absorb external impact applied to the display panel DP together with the protection member PM. Accordingly, deformation of the display panel DP may be further prevented or alleviated.

According to one or more embodiments of the present disclosure, a display device with improved display quality is provided.

Effects, aspects, and features according to embodiments of the present disclosure are not limited to the content exemplified above, and further various effects, aspects, and features are included in the present specification.

Although specific embodiments and application examples are described herein, other embodiments and modifications may be derived from the above description. Therefore, the scope of the present disclosure are not limited to these embodiments, and extends to the scope of the claims set forth below, various obvious modifications, and equivalents.

## Claims

1. A display device comprising:
a display panel (DP) above a substrate and comprising a display area;
a window layer (WDL) above the display panel and comprising a window overlapping the display area and a black matrix adjacent to the window;
a metal layer (ML) between the display panel and the substrate;
a protection member (PM) overlapping the black matrix and covering edges of the display panel, the display panel (DP) comprising side edges (SE1~SE4) and corner edges (CE1~CE4) connecting the side edges; and
an impact alleviation member (SRM) between at least one of the edges of the display panel and the protection member, and adjacent to at least one of the corner edges of the display panel.

2. The display device according to claim 1, wherein the impact alleviation member (SRM) comprises ink.

3. The display device according to claim 1 or 2, wherein the ink has an elastic modulus of (100) 100 Mpa or more and (1500) 1500 Mpa or less, .

4. The display device according to claim 2 or 3, wherein the ink comprises a urethane-based resin, an acryl-based resin, an ethylene-based resin, and/or a resin, or , wherein the ink comprises a conductive material.

5. The display device according to any of the preceding claims, wherein the impact alleviation member (SRM) has a closed loop shape along the edges of the display panel, and/or wherein the impact alleviation member (SRM) is adjacent to at least one of the side edges.

6. The display device according to any of the preceding claims, wherein the side edges (SE1~SE4) comprise:
a first side edge (SE1) and a second side edge (SE2) extending in a first direction; and
a third side edge (SE3) and a fourth side edge (SE4)extending in a second direction crossing the first direction, and shorter than the first and second side edges,
wherein the corner edges (CE1~CE4) comprise:
a first corner edge (CE1) connecting the first side edge and the third side edge;
a second corner edge (CE2) connecting the third side edge and the second side edge;
a third corner edge (CE3) connecting the first side edge and the fourth side edge; and
a fourth corner edge (CE4) connecting the fourth side edge and the second side edge, and
wherein the impact alleviation member (SRM) is adjacent to the third and fourth corner edges (CE3, CE4).

7. The display device according to any of the preceding claims, wherein a cross-section of the impact alleviation member (SRM) has a round end, and/or
wherein the impact alleviation member (SRM) comprises a first surface contacting at least one of the edges of the display panel, and a second surface opposite the first surface, and
wherein the second surface has a convex shape toward the protection member.

8. The display device according to any of the preceding claims, wherein the protection member (PM) and the impact alleviation member (SRM) have an elastic property, and/or wherein the protection member has a first elastic modulus, and
wherein the impact alleviation member (SRM) has a second elastic modulus that is less than the first elastic modulus.

9. The display device according to any of the preceding claims, further comprising:
a protection film (PF) between the display panel and the metal layer;
a polarizing layer (POL) between the display panel and the window layer; and
an adhesive layer (PSA) between the polarizing layer and the window layer,
wherein the impact alleviation member (SRM) directly contacts the metal layer, the protection film, the display panel, and the polarizing layer.

10. The display device according to claim 9, wherein the impact alleviation member (SRM) comprises a first impact alleviation member (SRM1) contacting the metal layer, and a second impact alleviation member (SRM2) contacting the polarizing layer,
wherein the first impact alleviation member comprises first ink, and
wherein the second impact alleviation member comprises second ink.

11. The display device according to claim 10, wherein the impact alleviation member (SRM) comprises a boundary surface between the first impact alleviation member and the second impact alleviation member.

12. The display device according to claim 9, wherein the impact alleviation member (SRM) contacts the adhesive layer, and contacts a portion of the window layer adjacent to the adhesive layer.

13. A method of manufacturing a display device of any of the preceding claims, the method comprising:
forming a display panel (DP) comprising a display area above a substrate and having edges, the display panel comprising side edges and corner edges connecting the side edges;
providing a window layer (WDL) comprising a window overlapping the display area and a black matrix that is adjacent to the window above the display panel;
forming a protection member (PM) that overlaps the black matrix, and that covers the edges of the display panel; and
forming an impact alleviation member (SRM) on at least one of edges of the display panel between the at least one of the edges of the display panel and the protection member and adjacent to at least one of the corner edges of the display panel.

14. The method according to claim 13, wherein forming the impact alleviation member (SRM) comprises applying ink to at least one of the edges of the display panel using a nozzle (11, 11'), and/or, further comprising curing the ink before the protection member is formed at the edges of the display panel.

15. The method according to claim 13 or 14, further comprising:
providing a metal layer between the display panel and the substrate; and
providing a polarizing layer (POL) between the display panel and the window layer,
wherein forming the impact alleviation member (SRM) comprises:
applying a first ink to contact the metal layer; and
applying a second ink to contact the polarizing layer.
